(19) Europäisches Patentamt
European Patent Office
Office européen des brevets

(11) **EP 4 425 258 A1**

(12) **EUROPEAN PATENT APPLICATION**
published in accordance with Art. 153(4) EPC

(43) Date of publication:
**04.09.2024 Bulletin 2024/36**

(21) Application number: **22887095.2**

(22) Date of filing: **26.10.2022**

(51) International Patent Classification (IPC):
**G03F 1/24** *(2012.01)*        **G03F 7/20** *(2006.01)*

(52) Cooperative Patent Classification (CPC):
**G03F 1/24; G03F 7/20**

(86) International application number:
**PCT/JP2022/040039**

(87) International publication number:
**WO 2023/074770 (04.05.2023 Gazette 2023/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.10.2021 JP 2021176757**

(71) Applicant: **Hoya Corporation**
**Tokyo 160-0023 (JP)**

(72) Inventors:
• **NAKAGAWA Masanori**
  **Tokyo 160-0023 (JP)**
• **SUZUKI Kota**
  **Tokyo 160-0023 (JP)**
• **KISHIDA Hibiki**
  **Tokyo 160-0023 (JP)**

(74) Representative: **Vossius & Partner**
**Patentanwälte Rechtsanwälte mbB**
**Siebertstrasse 3**
**81675 München (DE)**

(54) **MULTILAYER REFLECTIVE FILM-ATTACHED SUBSTRATE, REFLECTIVE MASK BLANK, REFLECTIVE MASK, AND METHOD FOR PRODUCING SEMICONDUCTOR DEVICE**

(57)    [Problem] To obtain a substrate with a multilayer reflective film (90) capable of suppressing a decrease in reflectance of a multilayer reflective film (2) with respect to EUV light for the substrate with a multilayer reflective film (90) having a structure in which a protective film (3) containing metal is disposed.

[Solution] A substrate with a multilayer reflective film (90) includes a substrate (1), a multilayer reflective film (2) on the substrate (1), and a protective film (3) on the multilayer reflective film (2). The protective film (3) includes a silicon-containing layer (32), a first layer (34), a second layer (36), and a third layer (38) in this order on the multilayer reflective film (2). The protective film (3) contains metal and nitrogen. When a nitrogen content of the first layer (34) is represented by N1, a nitrogen content of the second layer (36) is represented by N2, and a nitrogen content of the third layer (38) is represented by N3, N2 is larger than N1 and N3.

Fig. 1

**Description**

Technical Field

The present invention relates to a reflective mask used for manufacturing a semiconductor device or the like, a substrate with a multilayer reflective film used for manufacturing the reflective mask, and a reflective mask blank. The present invention also relates to a method for manufacturing a semiconductor device using the above reflective mask.

Background Art

With further demand for higher density and higher accuracy of a VLSI device in recent years, EUV lithography, which is an exposure technique using extreme ultraviolet (hereinafter, referred to as EUV) light, has been proposed.

A reflective mask includes a multilayer reflective film for reflecting exposure light, formed on a substrate, and an absorber pattern that is a patterned absorber film for absorbing exposure light, formed on the multilayer reflective film. An optical image reflected by the multilayer reflective film is transferred onto a semiconductor substrate (transfer object) such as a silicon wafer through a reflective optical system.

Examples of a reflective-layer-provided substrate for manufacturing a reflective mask used for EUV lithography include an EUV-lithography-reflective-layer-provided substrate described in Patent Literatures 1 and 2. Patent Literatures 1 and 2 describe an EUV-lithography-reflective-layer-provided substrate in which a reflective layer that reflects EUV light and a protective layer that protects the reflective layer are formed in this order on a substrate.

Patent Literature 1 describes an EUV-lithography-reflective-layer-provided substrate in which the reflective layer is a Mo/Si multilayer reflective film, the protective layer is a Ru layer or a Ru compound layer, and an intermediate layer is formed between the reflective layer and the protective layer. Furthermore, Patent Literature 1 describes the following. That is, the intermediate layer includes a first layer and a second layer. The first layer contains 0.5 to 25 at% of nitrogen and 75 to 99.5 at% of Si. The second layer contains 60 to 99.8 at% of Ru, 0.1 to 10 at% of nitrogen, and 0.1 to 30 at% of Si. The total film thickness of the first layer and the second layer is 0.2 to 2.5 nm. The first layer constituting the intermediate layer is formed on the reflective layer side, and the second layer is formed on the first layer. The protective layer does not substantially contain Si.

Patent Literature 2 describes an EUV-lithography-reflective-layer-provided substrate in which the reflective layer is a Mo/Si multilayer reflective film, the protective layer is a Ru layer or a Ru compound layer, and an intermediate layer containing 0.5 to 25 at% of nitrogen and 75 to 99.5 at% of Si is formed between the reflective layer and the protective layer.

Citation List

Patent Literature

   Patent Literature 1: WO 2012/014904 A
   Patent Literature 2: WO 2011/071123 A

Summary of Invention

Technical Problem

The above-described EUV lithography is an exposure technique using extreme ultraviolet light (EUV light). EUV light is light in a wavelength band of a soft X-ray region or a vacuum ultraviolet region, and is specifically light having a wavelength of about 0.2 to 100 nm. In the case of EUV lithography, EUV light having a wavelength of 13 to 14 nm (for example, a wavelength of 13.5 nm) can be used.

In the EUV lithography, a reflective mask having an absorber pattern is used. EUV light emitted to the reflective mask is absorbed in a portion where the absorber pattern is present, and is reflected in a portion where the absorber pattern is not present. A multilayer reflective film is exposed in a portion where the absorber pattern is not present. The multilayer reflective film exposed on a surface of the reflective mask reflects EUV light. In the EUV lithography, an optical image reflected by the multilayer reflective film (a portion where the absorber pattern is not present) is transferred onto a semiconductor substrate (transfer object) such as a silicon wafer through a reflective optical system.

As the multilayer reflective film, a multilayer film in which elements having different refractive indices are periodically laminated is generally used. For example, as a multilayer reflective film with respect to EUV light having a wavelength of 13 to 14 nm (for example, a wavelength of 13.5 nm), a Mo/Si periodic laminated film in which a Mo film having a low refractive index and a Si film having a high refractive index are alternately laminated for 40 to 60 periods is used.

In order to achieve high density and high accuracy of a semiconductor device using a reflective mask, it is necessary for a reflection region (a surface of a multilayer reflective film) in the reflective mask to have a high reflectance with respect to EUV light that is exposure light.

In a process of manufacturing the reflective mask, when an absorber pattern is formed, an absorber film is processed by etching via a resist pattern or an etching mask pattern. In order to process the absorber film into a designed shape, it is necessary to slightly over-etch the absorber film. At the time of over-etching, a multilayer reflective film under the absorber film is also damaged by etching. In order to prevent the multilayer reflective film from being damaged by etching, a protective film is formed between the absorber film and the multilayer reflective film. Therefore, the protective film needs to have high resistance to an etching gas used for etching the absorber film.

As a material of the protective film having high resistance to the etching gas of the absorber film, for example, metal such as Ru or RuNb is used. On the other hand, when a low refractive index layer such as a Mo film is an outermost surface of the multilayer reflective film, the low refractive index layer is easily oxidized. Oxidation of the low refractive index layer may reduce a reflectance of the reflective mask. Therefore, in general, a silicon-containing layer such as a Si film is disposed on the outermost surface of the multilayer reflective film. In a case where the substrate with a multilayer reflective film has a structure in which a protective film containing a metal material is disposed on a silicon-containing layer such as a Si film, when the substrate with a multilayer reflective film or the like is subjected to heat treatment in a process of manufacturing a reflective mask, a phenomenon that a reflectance of the multilayer reflective film with respect to EUV light decreases may occur. Note that the heat treatment on the substrate with a multilayer reflective film or the reflective mask blank may be generally performed for stress adjustment of the substrate with a multilayer reflective film or the reflective mask blank.

Therefore, an object of the present invention is to obtain a substrate with a multilayer reflective film capable of suppressing a decrease in reflectance of a multilayer reflective film with respect to EUV light even when the substrate with a multilayer reflective film is subjected to heat treatment. Another object of the present invention is to obtain a reflective mask blank or a reflective mask capable of suppressing a decrease in reflectance of a multilayer reflective film with respect to EUV light even when the reflective mask blank or the reflective mask is subjected to heat treatment.

Solution to Problem

In order to solve the above problems, the present invention has the following configurations.

(Configuration 1)

Configuration 1 is a substrate with a multilayer reflective film including a substrate, a multilayer reflective film on the substrate, and a protective film on the multilayer reflective film, in which

the protective film includes a silicon-containing layer, a first layer, a second layer, and a third layer in this order on the multilayer reflective film,
the protective film contains metal and nitrogen, and
when a nitrogen content of the first layer is represented by N1, a nitrogen content of the second layer is represented by N2, and a nitrogen content of the third layer is represented by N3, N2 is larger than N1 and N3.

(Configuration 2)

Configuration 2 is the substrate with a multilayer reflective film according to configuration 1, in which

when a metal content of the first layer is represented by M1, a metal content of the second layer is represented by M2, and a metal content of the third layer is represented by M3,
a relationship of $(M3/(N3 + M3) > M1/(N1 + M1) > M2/(N2 + M2))$ is satisfied.

(Configuration 3)

Configuration 3 is the substrate with a multilayer reflective film according to configuration 1 or 2, in which the first layer, the second layer, and the third layer satisfy a relationship of $N2 > N1 \geq N3$.

(Configuration 4)

Configuration 4 is the substrate with a multilayer reflective film according to configuration 1 or 2, in which the first layer, the second layer, and the third layer satisfy a relationship of N2 > N3 > N1.

(Configuration 5)

Configuration 5 is the substrate with a multilayer reflective film according to any one of configurations 1 to 4, in which the metal is at least one selected from ruthenium (Ru), rhodium (Rh), and iridium (Ir).

(Configuration 6)

Configuration 6 is the substrate with a multilayer reflective film according to any one of configurations 1 to 5, in which the protective film further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu).

(Configuration 7)

Configuration 7 is a reflective mask blank including a substrate, a multilayer reflective film on the substrate, a protective film on the multilayer reflective film, and an absorber film on the protective film, in which

the protective film includes a silicon-containing layer, a first layer, a second layer, and a third layer in this order on the multilayer reflective film,
the protective film contains metal and nitrogen, and
when a nitrogen content of the first layer is represented by N1, a nitrogen content of the second layer is represented by N2, and a nitrogen content of the third layer is represented by N3, N2 is larger than N1 and N3.

(Configuration 8)

Configuration 8 is the reflective mask blank according to configuration 7, in which

when a metal content of the first layer is represented by M1, a metal content of the second layer is represented by M2, and a metal content of the third layer is represented by M3,
a relationship of $(M3/(N3 + M3) > M1/(N1 + M1) > M2/(N2 + M2))$ is satisfied.

(Configuration 9)

Configuration 9 is the reflective mask blank according to configuration 7 or 8, in which the first layer, the second layer, and the third layer satisfy a relationship of N2 > N1 ≥ N3.

(Configuration 10)

Configuration 10 is the reflective mask blank according to configuration 7 or 8, in which the first layer, the second layer, and the third layer satisfy a relationship of N2 > N3 > N1.

(Configuration 11)

Configuration 11 is the reflective mask blank according to any one of configurations 7 to 10, in which the metal is at least one selected from ruthenium (Ru), rhodium (Rh), and iridium (Ir).

(Configuration 12)

Configuration 12 is the reflective mask blank according to any one of configurations 7 to 11, in which the protective film further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu).

(Configuration 13)

Configuration 13 is a reflective mask including a substrate, a multilayer reflective film on the substrate, a protective film on the multilayer reflective film, and an absorber pattern on the protective film, in which

the protective film includes a silicon-containing layer, a first layer, a second layer, and a third layer in this order on the multilayer reflective film,
the protective film contains metal and nitrogen, and
when a nitrogen content of the first layer is represented by N1, a nitrogen content of the second layer is represented by N2, and a nitrogen content of the third layer is represented by N3, N2 is larger than N1 and N3.

(Configuration 14)

Configuration 14 is the reflective mask according to configuration 13, in which

when a metal content of the first layer is represented by M1, a metal content of the second layer is represented by M2, and a metal content of the third layer is represented by M3,
a relationship of $(M3/(N3 + M3) > M1/(N1 + M1) > M2/(N2 + M2))$ is satisfied.

(Configuration 15)

Configuration 15 is the reflective mask according to configuration 13 or 14, in which the first layer, the second layer, and the third layer satisfy a relationship of $N2 > N1 \geq N3$.

(Configuration 16)

Configuration 16 is the reflective mask according to configuration 13 or 14, in which the first layer, the second layer, and the third layer satisfy a relationship of $N2 > N3 > N1$.

(Configuration 17)

Configuration 17 is the reflective mask according to any one of configurations 13 to 16, in which the metal is at least one selected from ruthenium (Ru), rhodium (Rh), and iridium (Ir).

(Configuration 18)

Configuration 18 is the reflective mask according to any one of configurations 13 to 17, in which the protective film further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu).

(Configuration 19)

Configuration 19 is a method for manufacturing a semiconductor device, including performing a lithography process by an exposure apparatus using the reflective mask according to any one of configurations 13 to 18 to form a transfer pattern on a transfer object.

Advantageous Effects of Invention

According to the present invention, it is possible to obtain a substrate with a multilayer reflective film capable of suppressing a decrease in reflectance of a multilayer reflective film with respect to EUV light even when the substrate with a multilayer reflective film is subjected to heat treatment. In addition, according to the present invention, it is possible to obtain a reflective mask blank or a reflective mask capable of suppressing a decrease in reflectance of a multilayer reflective film with respect to EUV light even when the reflective mask blank or the reflective mask is subjected to heat treatment.

Brief Description of Drawings

Fig. 1 is a schematic cross-sectional view illustrating an example of a substrate with a multilayer reflective film of the present embodiment.
Fig. 2 is a schematic cross-sectional view illustrating an example of a reflective mask blank of the present embodiment.
Fig. 3 is a schematic cross-sectional view illustrating another example of the reflective mask blank of the present embodiment.
Fig. 4 is a schematic cross-sectional view illustrating an example of a method for manufacturing the reflective mask blank of the present embodiment.
Fig. 5 is a schematic diagram illustrating an example of an EUV exposure apparatus.

Description of Embodiments

Hereinafter, an embodiment of the present invention will be specifically described with reference to the drawings. Note that the following embodiment is a form for specifically describing the present invention and does not limit the present invention within the scope thereof.

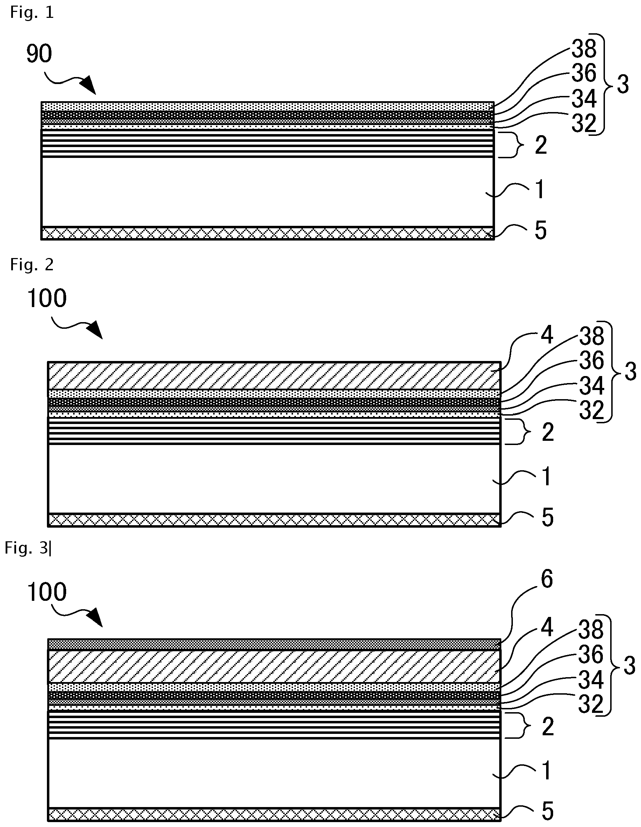

Fig. 1 is a schematic cross-sectional view illustrating an example of a substrate with a multilayer reflective film 90 of the present embodiment. A substrate with a multilayer reflective film 90 illustrated in Fig. 1 includes a multilayer reflective film 2 and a protective film 3 on a substrate 1. The protective film 3 includes a silicon-containing layer 32, a first layer 34, a second layer 36, and a third layer 38 in this order on the multilayer reflective film 2. Note that the substrate with a multilayer reflective film 90 can further include another thin film such as a back conductive film 5.

Fig. 2 is a schematic cross-sectional view illustrating an example of a reflective mask blank 100 of the present embodiment. The reflective mask blank 100 illustrated in Fig. 2 includes the multilayer reflective film 2, the protective film 3, and an absorber film 4 on the substrate 1. The reflective mask blank 100 can include the back conductive film 5. Note that the substrate with a multilayer reflective film 90 can further include another thin film such as a resist film 11.

Fig. 3 is a schematic cross-sectional view illustrating another example of the reflective mask blank 100. The reflective mask blank 100 illustrated in Fig. 3 further includes an etching mask film 6 on the absorber film 4 in addition to the configuration illustrated in Fig. 2. Note that the reflective mask blank 100 can further include another thin film such as the resist film 11.

In the present specification, "disposing (forming) a thin film B on a thin film A (or a substrate)" means not only disposing (forming) the thin film B in contact with a surface of the thin film A (or the substrate) but also disposing (forming) another thin film C between the thin film A (or the substrate) and the thin film B. In addition, in the present specification, for example, "disposing a thin film B in contact with a surface of a thin film A (or a substrate)" means disposing the thin film A and the thin film B so as to be in direct contact with each other without interposing another thin film between the thin film A (or a substrate) and the thin film B. In addition, in the present specification, "on" does not necessarily mean an upper side in the vertical direction. "On" merely indicates a relative positional relationship among a thin film, the substrate 1, and the like.

<Substrate with a multilayer reflective film 90>

The substrate with a multilayer reflective film 90 of the present embodiment will be specifically described.

<<Substrate 1>>

The substrate 1 preferably has a low thermal expansion coefficient within a range of $0 \pm 5$ ppb/°C in order to prevent distortion of a transfer pattern due to heat during exposure with EUV light. As a material having a low thermal expansion coefficient in this range, $SiO_2$-$TiO_2$ based glass, multicomponent glass ceramics, or the like can be used, for example.

A main surface (first main surface) of the substrate 1 on which a transfer pattern (absorber pattern 4a described later) is to be formed is preferably processed in order to increase flatness. By increasing the flatness of the main surface of the substrate 1, positional accuracy and transfer accuracy of the pattern can be enhanced. For example, in a case of EUV exposure, in a region of 132 mm $\times$ 132 mm of the main surface of the substrate 1 on which the transfer pattern is to be formed, the flatness is preferably 0.1 um or less, more preferably 0.05 $\mu$m or less, and particularly preferably 0.03 $\mu$m or less. A second main surface (back surface) opposite to the side on which the transfer pattern is to be formed is a surface to be fixed to an exposure apparatus by an electrostatic chuck. In a region of 142 mm $\times$ 142 mm of the back surface, the flatness is 0.1 $\mu$m or less, more preferably 0.05 um or less, and particularly preferably 0.03 $\mu$m or less.

Note that, in the present specification, the flatness is a value representing warpage (deformation amount) of a surface, indicated by total indicated reading (TIR). The flatness (TIR) is an absolute value of a difference in height between the highest position of a surface of the substrate 1 above a focal plane and the lowest position of the surface of the substrate 1 below the focal plane, in which the focal plane is a plane determined by a least squares method using the surface of the substrate 1 as a reference.

In a case of EUV exposure, surface roughness of the main surface of the substrate 1 on which the transfer pattern is to be formed is preferably 0.1 nm or less in terms of root mean square roughness (Rq). Note that the surface roughness can be measured by an atomic force microscope.

The substrate 1 preferably has high stiffness in order to prevent deformation of a thin film (such as the multilayer reflective film 2) to be formed on the substrate 1 due to film stress. In particular, the substrate 1 preferably has a high Young's modulus of 65 GPa or more.

«Multilayer reflective film 2»

The substrate with a multilayer reflective film 90 according to the embodiment includes the multilayer reflective film 2. The multilayer reflective film 2 provides a function of reflecting EUV light in the reflective mask 200. The multilayer reflective film 2 is a multilayer film in which layers containing elements having different refractive indices as main components are periodically laminated.

In general, as the multilayer reflective film 2, a multilayer film in which a thin film containing a light element which is a high refractive index material or a compound thereof (a high refractive index layer) and a thin film containing a heavy element which is a low refractive index material or a compound thereof (a low refractive index layer) are alternately laminated for about 40 to 60 periods is used.

The multilayer film used as the multilayer reflective film 2 can have a structure in which a laminated structure of a high refractive index layer/a low refractive index layer in which the high refractive index layer and the low refractive index layer are laminated in this order from the substrate 1 side as one period is laminated for a plurality of periods. In addition, in the multilayer film, a laminated structure of a low refractive index layer/a high refractive index layer in which the low refractive index layer and the high refractive index layer are laminated in this order from the substrate 1 side as one period can be laminated for a plurality of periods. Note that an outermost layer of the multilayer reflective film 2, that is, a surface layer of the multilayer reflective film 2 opposite to the substrate 1 is preferably a high refractive index layer. In the above-described multilayer film, if a laminated structure of a high refractive index layer/a low refractive index layer in which the high refractive index layer and the low refractive index layer are laminated in this order from the substrate 1 side as one period is laminated for a plurality of periods, the uppermost layer is the low refractive index layer. In this case, if the low refractive index layer constitutes the outermost surface of the multilayer reflective film 2, the low refractive index layer is easily oxidized, and the reflectance of the reflective mask 200 decreases. Therefore, it is preferable to further form the high refractive index layer on the uppermost low refractive index layer to form the multilayer reflective film 2. Note that the high refractive index layer formed on the uppermost low refractive index layer can be the silicon-containing layer 32 of the protective film 3 described later. On the other hand, in the above-described multilayer film, if a laminated structure of a low refractive index layer/a high refractive index layer in which the low refractive index layer and the high refractive index layer are laminated in this order from the substrate 1 side as one period is laminated for a plurality of periods, the uppermost layer is the high refractive index layer. Therefore, in this case, it is not necessary to further form the high refractive index layer. Note that the uppermost high refractive index layer in this case can also serve as the silicon-containing layer 32 of the protective film 3 described later.

As the high refractive index layer, a layer containing silicon (Si) can be used. As a material containing Si, in addition to Si alone, a Si compound containing boron (B), carbon (C), nitrogen (N), and oxygen (O), and/or hydrogen (H) in addition to Si can be used. By using a high refractive index layer containing Si, it is possible to obtain the reflective mask 200 having an excellent reflectance of EUV light. As the low refractive index layer, a simple metal selected from molybdenum (Mo), ruthenium (Ru), rhodium (Rh), and platinum (Pt), or an alloy thereof can be used. Boron (B), carbon (C), nitrogen (N), oxygen (O), and/or hydrogen (H) may be added to the simple metal or the alloy. In the substrate with a multilayer reflective film 90 of the present embodiment, the low refractive index layer is preferably a molybdenum (Mo) layer, and the high refractive index layer is preferably a silicon (Si) layer. For example, as the multilayer reflective film 2 for reflecting EUV light having a wavelength of 13 nm to 14 nm (for example, a wavelength of 13.5 nm), a Mo/Si periodic laminated film in which a Mo layer and a Si layer are alternately laminated for about 40 to 60 periods can be preferably used. In addition, in the substrate with a multilayer reflective film 90 of the present embodiment, the low refractive index layer is preferably a ruthenium (Ru) layer, and the high refractive index layer is preferably a silicon (Si) layer. For example, as the multilayer reflective film 2 for reflecting EUV light having a wavelength of 13 nm to 14 nm (for example, a wavelength of 13.5 nm), a Ru/Si periodic laminated film in which a Ru layer and a Si layer are alternately laminated for about 30 to 40 periods can be preferably used.

The reflectance of the multilayer reflective film 2 alone is usually 65% or more, and an upper limit thereof is usually 73%. Note that the film thickness and period of each constituent layer of the multilayer reflective film 2 can be appropriately selected according to an exposure wavelength. Specifically, the film thickness and period of each constituent layer of the multilayer reflective film 2 can be selected so as to satisfy the Bragg reflection law. In the multilayer reflective film 2, there are a plurality of high refractive index layers and a plurality of low refractive index layers, and the film thicknesses of the high refractive index layers do not necessarily need to be the same, and the film thicknesses of the low refractive index layers do not necessarily need to be the same.

A method for forming the multilayer reflective film 2 is known in the art. The multilayer reflective film 2 can be formed by depositing each layer by, for example, an ion beam sputtering method. In the case of the Mo/Si periodic multilayer film described above, for example, by an ion beam sputtering method, a Si film having a thickness of about 4 nm is first deposited on the substrate 1 using a Si target, then a Mo film having a thickness of about 3 nm is deposited using a Mo target, and this laminated structure as one period is laminated for 40 to 60 periods to form the multilayer reflective film 2 (an outermost layer thereof is a Si film). Note that, in a case of 60 periods, the number of steps is larger than that in a case of 40 periods, but the reflectance with respect to EUV light can be increased.

<<Protective film 3»

As illustrated in Fig. 1, the substrate with a multilayer reflective film 90 of the present embodiment preferably includes the predetermined protective film 3 on the multilayer reflective film 2. By inclusion of the protective film 3 on the multilayer reflective film 2, it is possible to suppress damage to a surface of the multilayer reflective film 2 when the reflective mask 200 is manufactured using the substrate with a multilayer reflective film 90. Therefore, a reflectance characteristic of the obtained reflective mask 200 with respect to EUV light is favorable.

In the present specification, the predetermined protective film 3 that can be used for the substrate with a multilayer reflective film 90 of the present embodiment may be referred to as "protective film 3 of the present embodiment".

The protective film 3 of the present embodiment includes the silicon-containing layer 32, the first layer 34, the second layer 36, and the third layer 38 in this order on the multilayer reflective film 2.

<<<Silicon-containing layer 32>>>

The silicon-containing layer 32 of the protective film 3 of the present embodiment can be disposed on the multilayer reflective film 2 in contact with the multilayer reflective film 2. The silicon-containing layer 32 contains at least silicon (Si). The silicon-containing layer 32 can be composed of only silicon (Si). Note that, when the uppermost layer of the multilayer reflective film 2 is a high refractive index layer, the uppermost high refractive index layer can also serve as the silicon-containing layer 32 of the protective film 3. When the silicon-containing layer 32 is deposited, the silicon-containing layer 32 can be deposited under a condition for depositing a film consisting of only silicon (Si). For example, the silicon-containing layer 32 can be deposited by an ion beam sputtering method using a Si target.

The film thickness of the silicon-containing layer 32 is preferably 1.0 to 2.0 nm, and more preferably 1.2 to 1.5 nm. Note that the film thickness of the silicon-containing layer 32 can be obtained by depositing the first layer 34, the second layer 36, and the third layer 38, and then observing a cross-sectional transmission electron microscope (TEM) image and/or measuring a composition profile in a depth direction by an X-ray photoelectron spectroscopy method (XPS) or an energy dispersive X-ray analysis method (EDX method) using a scanning transmission electron microscope (STEM). The first layer 34, the second layer 36, and the third layer 38 each contain a predetermined metal. Therefore, a part of silicon in the silicon-containing layer 32 is diffused into the first layer 34 and the like after the first layer 34, the second layer 36, and the third layer 38 are deposited. Therefore, the film thickness of the silicon-containing layer 32 immediately after the deposition (film thickness calculated from a relationship between a deposition speed and a deposition time) may decrease after the first layer 34, the second layer 36, and the third layer 38 are deposited. Note that the same applies to the film thicknesses of the other layers constituting the protective film 3. The film thickness of each layer constituting the protective film 3 can be obtained by measuring a composition profile in a depth direction by the XPS method.

<<<First layer 34>>>

The first layer 34 of the protective film 3 of the present embodiment is disposed on the silicon-containing layer 32 in contact with the silicon-containing layer 32. The first layer 34 can contain metal, silicon (Si), and/or nitrogen (N). The first layer 34 preferably contains metal, silicon, and nitrogen. In the present specification, the nitrogen content of the first layer 34 is represented by N1 (atom%). The nitrogen content N1 of the first layer 34 satisfies N1 ≥ 0 atom%.

The film thickness of the first layer 34 is preferably 0.5 to 1.5 nm, and more preferably 0.8 to 1.1 nm.

<<<Second layer 36>>>

The second layer 36 of the protective film 3 of the present embodiment is disposed on the first layer 34 in contact with the first layer 34. The second layer 36 contains metal and nitrogen (N). The second layer 36 can further contain silicon (Si). The second layer 36 preferably contains metal, silicon, and nitrogen. In the present specification, the nitrogen content of the second layer 36 is represented by N2 (atom%). The nitrogen content N2 of the second layer 36 satisfies N2 > 0 atom%.

The film thickness of the second layer 36 is preferably 0.5 to 1.5 nm, and more preferably 1.0 to 1.2 nm.

<<<Third layer 38>>>

The third layer 38 of the protective film 3 of the present embodiment is disposed on the second layer 36 in contact with the second layer 36. The third layer 38 can have a function as the protective film 3 of increasing resistance of the protective film 3 to an etching gas and resistance of the protective film 3 to cleaning. The nitrogen (N) content of the third layer 38 is preferably low, and the third layer 38 more preferably contains no nitrogen. In the present specification, the nitrogen content of the third layer 38 is represented by N3 (atom%). The nitrogen content N3 of the third layer 38 satisfies N3 ≥ 0 atom%.

In the present specification, metal that is contained in the third layer 38 and used for exhibiting a function as the protective film 3 may be referred to as "predetermined metal". The predetermined metal contained in the third layer 38 is preferably at least one selected from ruthenium (Ru), rhodium (Rh), and iridium (Ir). The third layer 38 is preferably composed of only at least one selected from ruthenium (Ru), rhodium (Rh), and iridium (Ir) .

The film thickness of the third layer 38 is preferably 1.5 to 5.0 nm, and more preferably 2.0 to 4.0 nm.

Note that, since the above-described silicon-containing layer 32, first layer 34, second layer 36, and third layer 38 are very thin films, it may be difficult to clearly specify an interface between the layers by measurement. In this case, for example, by observing a cross-sectional TEM image, it is possible to specify a position considered to be an interface between the layers. In addition, a composition profile of the protective film 3 in a depth direction is measured by an XPS method or an EDX method, and a position considered to be an interface between the layers can be specified from the composition profile.

In addition, since the above-described silicon-containing layer 32, first layer 34, second layer 36, and third layer 38 are very thin films, it may be difficult to clearly specify a composition of each of the layers by measurement. In this case, for example, an interface is specified by observing a cross-sectional TEM image, and/or a composition profile of the protective film 3 in a depth direction is measured by an XPS method or an EDX method, and a position where a signal of each element is a half value of a local maximum value or a maximum value is specified as an interface. The center of each layer in a film thickness direction is obtained from the position of the interface between the layers, and a composition (contents of metal, nitrogen, silicon, and the like) at the center of each layer in the film thickness direction can be defined as the composition of each layer. In the measurement by the XPS method or the EDX method, the composition of each layer may be specified by performing the measurement from a state of a reflective mask blank including absorber film 4 or the absorber film 4 and the etching mask film 6 on the protective film 3 or a state of a reflective mask after the absorber film 4 is patterned. Note that, when the composition at the center of each layer in the film thickness direction is defined as the composition of each layer, a distance from a surface of the protective film 3 to the center of each layer in the film thickness direction may be referred to as "measurement depth". The "measurement depth" means a distance in the film thickness direction from the surface of the protective film 3 for determining the composition of each layer.

In addition, as described above, since the silicon-containing layer 32, the first layer 34, the second layer 36, and the third layer 38 are very thin films, it may be difficult to clearly specify the composition of each layer by measurement. In this case, for example, a composition profile of the protective film 3 in a depth direction is measured by an XPS method or an EDX method, and a local maximum value or a local minimum value (or a maximum value or a minimum value) of the content of metal, nitrogen, silicon, or the like in a range of each layer can be defined as the content of metal, nitrogen, or silicon in the layer. In addition, when the depth at which a local maximum value of the content of metal in the first layer 34 occurs is represented by a measurement depth d1 of the first layer 34, a measurement value at the measurement depth d1 can be defined as the content of metal, nitrogen, or silicon in the first layer 34. In addition, when the depth at which a local maximum value of the content of nitrogen in the second layer 36 occurs is represented by a measurement depth d2 of the second layer 36, a measurement value at the measurement depth d2 can be defined as the content of metal, nitrogen, or silicon in the second layer 36. In addition, when the depth at which a local maximum value of the content of metal in the third layer 38 occurs is represented by a measurement depth d3 of the third layer 38, a measurement value at the measurement depth d3 can be defined as the content of metal, nitrogen, or silicon in the third layer 38.

In addition, as described above, since the silicon-containing layer 32, the first layer 34, the second layer 36, and the third layer 38 are very thin films, it may be difficult to clearly specify the composition of each layer by measurement.

In this case, for example, a composition profile of the protective film 3 in a depth direction is measured by an XPS method or an EDX method, a measurement depth is specified using $M/(N + M)$ that is a ratio between a nitrogen content N and a predetermined metal content M in a range of each layer or $M/(N + Si + M)$ that is a ratio among the nitrogen content N, the predetermined metal content M, and a silicon content Si, and the content of each layer can be specified. For example, a measurement value at a depth at which a local maximum value or a local minimum value (or a maximum value or a minimum value) of $M/(N + M)$ or $M/(N + Si + M)$ occurs can be defined as the content of metal, nitrogen, or silicon in the layer. In addition, when a depth at which a local maximum value or a local minimum value (or a maximum value or a minimum value) of $M/(N + M)$ or $M/(N + Si + M)$ occurs in the first layer 34 is defined as the measurement depth d1 of the first layer 34, a measurement value at the measurement depth d1 can be defined as the content (M1, N1, or Si1) of metal, nitrogen, or silicon in the first layer 34. In addition, when a depth at which a local maximum value or a local minimum value (or a maximum value or a minimum value) of $M/(N + M)$ or $M/(N + Si + M)$ occurs in the second layer 36 is defined as the measurement depth d2 of the second layer 36, a measurement value at the measurement depth d2 can be defined as the content (M2, N2, or Si2) of metal, nitrogen, or silicon in the second layer 36. In addition, when a depth at which a local maximum value or a local minimum value (or a maximum value or a minimum value) of $M/(N + M)$ or $M/(N + Si + M)$ occurs in the third layer 38 is defined as the measurement depth d3 of the third layer 38, a measurement value at the measurement depth d3 can be defined as the content (M3, N3, or Si3) of metal, nitrogen, or silicon in the third layer 38.

Note that, in the EDX method, when there is a layer containing Ta immediately above the protective film 3, an M-line of Ta overlaps with a K-line of Si, and therefore it is difficult to accurately quantify Si. In such a film configuration, $M/(N + M)$ not containing silicon is more preferable as a ratio for specifying a measurement depth than $M/(N + Si + M)$ containing silicon. On the other hand, in the EDX method, when a composition profile of $M/(N + M)$ in a depth direction is measured using a structure in which the intensity of a K-line of nitrogen is relatively low and the nitrogen content is low, an S/N ratio is deteriorated, which may adversely affect analysis. In such a film configuration, $M/(N + Si + M)$ is more preferable as a ratio for specifying the measurement depth than $M/(N + M)$.

In addition, the contents of metal and nitrogen in the above-described silicon-containing layer 32, first layer 34, second layer 36, and third layer 38 can be such contents that a composition gradient continuously changing in the depth direction of each layer is obtained. Also in this case, the composition of each layer of the protective film 3 can be obtained by the above-described method.

The protective film 3 of the embodiment contains metal and nitrogen. As described above, the second layer 36 contains at least metal and nitrogen, and the third layer 38 contains at least metal. Therefore, the protective film 3 as a whole contains metal and nitrogen. Note that the types of metal contained in the first layer 34, the second layer 36, and the third layer 38 can be the same (predetermined metal).

In the protective film 3 of the embodiment, when the nitrogen content of the first layer 34 is represented by N1, the nitrogen content of the second layer 36 is represented by N2, and the nitrogen content of the third layer 38 is represented by N3, N2 is larger than N1 and N3. This makes it possible to suppress diffusion of silicon (Si) from the silicon-containing layer 32 to the third layer 38 (layer having a function as the protective film 3). Therefore, it is possible to obtain the substrate with a multilayer reflective film 90 capable of suppressing a decrease in reflectance of the multilayer reflective film 2 with respect to EUV light even when the substrate with a multilayer reflective film 90 is subjected to heat treatment.

In the protective film 3 of the embodiment, the nitrogen content N1 of the first layer 34, the nitrogen content N2 of the second layer 36, and the nitrogen content N3 of the third layer 38 satisfy a relationship of $N2 > N1 \geq N3$. This relationship is more preferable when the protective film 3 contains at least one additive element selected from hafnium (Hf), titanium (Ti), zirconium (Zr), vanadium (V), niobium (Nb), and molybdenum (Mo). This is because an extinction coefficient k increases and a reflectance of EUV light decreases as a nitriding ratio of the third layer 38 increases. Note that this relationship is preferably $N2 > N1 > N3$.

In the protective film 3 of the embodiment, the nitrogen content N1 of the first layer 34, the nitrogen content N2 of the second layer 36, and the nitrogen content N3 of the third layer 38 satisfy a relationship of $N2 > N3 > N1$. This relationship is more preferable when the protective film 3 contains at least one additive element selected from manganese (Mn), indium (In), tantalum (Ta), silver (Ag), zinc (Zn), chromium (Cr), and tungsten (W). This is because an extinction coefficient k decreases and a reflectance of EUV light increases as a nitriding ratio of the third layer 38 increases.

The present inventors have found that when the nitrogen content of each layer of the protective film 3 is a predetermined value, it is possible to suppress a decrease in reflectance of the multilayer reflective film 2 with respect to EUV light even when the substrate with a multilayer reflective film 90 is subjected to heat treatment. By disposing the protective film 3 of the embodiment on the multilayer reflective film 2, it is possible to more effectively suppress a decrease in reflectance of the multilayer reflective film 2 with respect to EUV light. That is, in the present embodiment, it is possible to obtain the substrate with a multilayer reflective film 90 capable of suppressing a decrease in reflectance of the multilayer reflective film 2 with respect to EUV light even when the substrate with a multilayer reflective film 90 having a structure in which the protective film 3 made of a material containing the predetermined metal is disposed is subjected to heat treatment. In particular, when the types of metal contained in the protective film 3 is the same, the substrate with a multilayer reflective film 90 including the protective film 3 of the present embodiment, having a predetermined nitrogen content can suppress a decrease in reflectance of the multilayer reflective film 2 with respect to EUV light even when the substrate with a multilayer reflective film 90 is subjected to heat treatment, as compared with the protective film 3 substantially containing no nitrogen. In addition, in the present embodiment, it is possible to obtain a reflective mask blank or a reflective mask including the substrate with a multilayer reflective film 90 capable of suppressing a decrease in reflectance of the multilayer reflective film 2 with respect to EUV light even when the reflective mask blank or the reflective mask including the substrate with a multilayer reflective film 90 having a structure in which the protective film 3 containing the predetermined metal is disposed is subjected to heat treatment.

In the protective film 3 of the present embodiment, when the nitrogen content of the first layer 34 is represented by N1, the metal content of the first layer 34 is represented by M1, and the silicon content of the first layer 34 is represented by Si1, the nitrogen content of the second layer 36 is represented N2, the metal content of the second layer 36 is represented M2, the silicon content of the second layer 36 is represented Si2, the nitrogen content of the third layer 38 is represented N3, the metal content of the third layer 38 is represented M3, and the silicon content of the third layer 38 is represented Si3,

a relationship of $N2/(N2 + Si2 + M2) > N1/(N1 + Si1 + M1) > N3/(N3 + Si3 + M3)$ is preferably satisfied. Note that the types of metal contained in the first layer 34, the second layer 36, and the third layer 38 can be the same (predetermined metal). The metal contained in the first layer 34, the second layer 36, and the third layer 38 may include a plurality of metals, and the metal content in this case is the total content of the plurality of metals. Note that the metals herein are metals as main components constituting the first layer 34, the second layer 36, and the third layer 38, and the content of an additive element is not included in the total content of the metals. Since the contents of nitrogen, metal, and silicon in the first layer 34, the second layer 36, and the third layer 38 have a predetermined relationship, it is possible to more effectively suppress a phenomenon that silicon (Si) is diffused from the silicon-containing layer 32 to the third layer 38 during heat treatment.

When the multilayer reflective film 2 is, for example, a Mo/Si periodic laminated film, since Mo is easily oxidized by the air, the reflectance of the multilayer reflective film 2 may decrease. Therefore, an uppermost layer of the multilayer reflective film 2 is a Si layer. The silicon-containing layer 32 of the protective film 3 of the present embodiment can also serve as the Si film of the uppermost layer of the multilayer reflective film 2. In the conventional substrate with a multilayer reflective film 90, when a Si film and the single-layer protective film 3 containing Ru are in contact with each other, silicon (Si) may be easily diffused into the protective film 3. That is, in the conventional substrate with a multilayer reflective film 90, Si atoms move and are diffused between grain boundaries of the Ru-based protective film 3 from the Si layer of the multilayer reflective film 2 toward the Ru-based protective film 3 over time, thereby forming Ru silicide (RuSi). In particular, when the substrate with a multilayer reflective film 90 is subjected to heat treatment, diffusion of Si atoms from the Si layer of the multilayer reflective film 2 to the protective film 3 increases. Therefore, there arises a problem that the reflectance of the multilayer reflective film 2 decreases. Since the protective film 3 of the present embodiment includes the first layer 34 and the second layer 36 each having a predetermined nitrogen content, diffusion of silicon (Si) from the silicon-containing layer 32 to the third layer 38 (layer having a function as the protective film 3) can be suppressed. Therefore, it is possible to obtain the substrate with a multilayer reflective film 90 capable of suppressing a decrease in reflectance of the multilayer reflective film 2 with respect to EUV light even when the substrate with a multilayer reflective film 90 is subjected to heat treatment.

In the protective film 3 of the present embodiment, when the nitrogen content of the first layer 34 is represented by N1, the metal content of the first layer 34 is represented by M1, the nitrogen content of the second layer 36 is represented N2, the metal content of the second layer 36 is represented M2, the nitrogen content of the third layer 38 is represented N3, and the metal content of the third layer 38 is represented M3,

a relationship of $M3/(N3 + M3) > M1/(N1 + M1) > M2/(N2 + M2)$ is preferably satisfied.

In the protective film 3 of the present embodiment, when the nitrogen content of the first layer 34 is represented by N1, the metal content of the first layer 34 is represented by M1, and the silicon content of the first layer 34 is represented by Si1, the nitrogen content of the second layer 36 is represented N2, the metal content of the second layer 36 is represented M2, the silicon content of the second layer 36 is represented Si2, the nitrogen content of the third layer 38 is represented N3, the metal content of the third layer 38 is represented M3, and the silicon content of the third layer 38 is represented Si3,

a relationship of $M3/(N3 + Si3 + M3) > M1/(N1 + Si1 + M1) > M2/(N2 + Si2 + M2)$ is preferably satisfied.

Note that the types of metal contained in the first layer 34, the second layer 36, and the third layer 38 can be the same (predetermined metal). The metal contained in the first layer 34, the second layer 36, and the third layer 38 may include a plurality of metals, and the metal content in this case is the total content of the plurality of metals. Note that the metals herein are metals as main components constituting the first layer 34, the second layer 36, and the third layer 38, and the content of an additive element is not included in the total content of the metals. Since the metal contents in the first layer 34, the second layer 36, and the third layer 38 have a predetermined relationship, it is possible to more effectively suppress a phenomenon that silicon (Si) is diffused from the silicon-containing layer 32 to the third layer 38 during heat treatment. In addition, since the metal content in the third layer 38 disposed on an outermost surface of the protective film 3 is high, the protective film 3 as a whole can have a function as the protective film 3.

The metal contained in the protective film 3 of the present embodiment is preferably at least one selected from ruthenium (Ru), rhodium (Rh), and iridium (Ir). These metals can be contained as predetermined metals in the first layer 34, the second layer 36, and the third layer 38. In order to facilitate manufacture of the substrate with a multilayer reflective film 90, the predetermined metals contained in the first layer 34, the second layer 36, and the third layer 38 are preferably the same type of metal.

Since the metal contained in the protective film 3 of the present embodiment is at least one (specific metal) selected from ruthenium (Ru), rhodium (Rh), and iridium (Ir), it is possible to effectively obtain a function as the protective film 3 of enhancing resistance of the protective film 3 to an etching gas and resistance of the protective film 3 to cleaning. In addition, ruthenium (Ru), rhodium (Rh), and iridium (Ir) are materials that hardly react with nitrogen. Therefore, by inclusion of a specific metal in the third layer 38, it is possible to suppress the third layer 38 from containing nitrogen (N). As a result, a phenomenon that silicon (Si) is diffused into the third layer 38 can be more effectively suppressed.

In the substrate with a multilayer reflective film 90 of the present embodiment, the protective film 3 preferably further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu). By further inclusion of an additive element in the protective film 3, adhesion of an interface between the silicon-containing layer 32 and the first layer 34 can be enhanced. Therefore, at least one of the silicon-containing layer 32 and the first layer 34 preferably contains an additive element.

Preferably, the first layer 34, the second layer 36, and the third layer 38 are continuously deposited. Therefore, in consideration of productivity when the protective film 3 is formed, not only the first layer 34 but also the second layer 36 and the third layer 38 can further contain an additive element.

In the protective film 3 of the present embodiment, the content of an additive element in the first layer 34, the second layer 36, and the third layer 38 is preferably 2 atom% or more, and more preferably 3 atom% or more. In addition, the content of an additive element is preferably 15 atom% or less, and more preferably 10 atom% or less. By adjusting the addition amount of an additive element, adhesion of an interface between the silicon-containing layer 32 and the first layer 34 can be further enhanced.

The first layer 34, the second layer 36, and the third layer 38 of the protective film 3 of the present embodiment can be formed by various known methods, for example, an ion beam sputtering method, a sputtering method, a reactive sputtering method, a vapor phase growth method (CVD), and a vacuum vapor deposition method. The protective film 3 of the present embodiment is preferably deposited by a magnetron sputtering method (reactive sputtering method) in a nitrogen gas atmosphere. As a target, for example, at least one single metal target or alloy target selected from ruthenium (Ru), rhodium (Rh), and iridium (Ir) can be used. When the first layer 34, the second layer 36, and the third layer 38 are deposited by a reactive sputtering method, the first layer 34, the second layer 36, and the third layer 38 can be continuously deposited in a nitrogen gas atmosphere after the silicon-containing layer 32 is deposited.

When the first layer 34, the second layer 36, and the third layer 38 are continuously deposited, each layer having a predetermined composition can be deposited by changing deposition conditions such as a flow rate (pressure) of a nitrogen gas and/or applied power. Note that, when appropriate deposition conditions are selected, even when the first layer 34, the second layer 36, and the third layer 38 are deposited while the deposition conditions are kept constant, each layer having a predetermined composition can be deposited by diffusion of a predetermined element in the first layer 34, the second layer 36, and the third layer 38. For example, the first layer 34 containing silicon (Si) can be formed by diffusion of silicon (Si) from the silicon-containing layer 32.

After the protective film 3 is formed or after the absorber film 4 is formed, the resulting product can be subjected to heat treatment. In this heat treatment, heating can be performed at a temperature higher than a prebaking temperature (about 110°C) of the resist film 11 in a process of manufacturing the reflective mask blank 100. Specifically, a temperature condition of the heat treatment is usually 130°C or higher and 300°C or lower, and preferably 150°C or higher and 250°C or lower. By performing the heat treatment, stress of the substrate 1 and the thin film formed on the substrate 1 can be adjusted. The substrate with a multilayer reflective film 90 and the reflective mask blank 100 of the present embodiment can suppress a decrease in reflectance of the multilayer reflective film 2 with respect to EUV light even when the substrate with a multilayer reflective film 90 and the reflective mask blank 100 are subjected to heat treatment.

Note that by performing the above heat treatment, it may be possible to obtain the first layer 34 and the second layer 36 each having a more preferable composition for promoting diffusion of nitrogen contained in the first layer 34, the second layer 36, and the third layer 38 and suppressing diffusion of Si into the third layer 38.

The total film thickness (also simply referred to as "film thickness of the protective film 3") of the first layer 34, the second layer 36, and the third layer 38 of the protective film 3 is not particularly limited as long as a function as the protective film 3 can be exhibited. The film thickness of the protective film 3 is preferably 1.0 nm to 8.0 nm, and more preferably 1.5 nm to 6.0 nm from a viewpoint of the reflectance of EUV light.

A desired configuration of the above-described protective film 3 can be confirmed not only from the protective film 3 in the substrate with a multilayer reflective film 90 before the absorber film 4 is formed, but also from the reflective mask blank 100 including the absorber film 4 and the etching mask film 6 or the reflective mask 200 including the protective film 3 after the absorber film 4 is patterned.

<<Back conductive film 5>>

The substrate with a multilayer reflective film 90 of the present embodiment can further include the back conductive film 5 for an electrostatic chuck. The back conductive film 5 can be formed on a second main surface (back main surface) of the substrate 1 (on a side opposite to the surface on which the multilayer reflective film 2 is formed, and on an intermediate layer when an intermediate layer such as a hydrogen entry preventing film is formed on the substrate 1). Sheet resistance required for the back conductive film 5 for an electrostatic chuck is usually 100 $\Omega/\square$ ($\Omega$/square) or less. A method for forming the back conductive film 5 is, for example, a magnetron sputtering method or an ion beam sputtering method using a target of metal such as chromium or tantalum or an alloy thereof. A material containing chromium (Cr) of the back conductive film 5 is preferably a Cr compound containing at least one selected from boron, nitrogen, oxygen, and carbon in addition to Cr. Examples of the Cr compound include CrN, CrON, CrCN, CrCON, CrBN, CrBON, CrBCN, CrBOCN, and the like. As a material containing tantalum (Ta) of the back conductive film 5, it is preferable to use tantalum (Ta), an alloy containing Ta, or a Ta compound containing at least one of boron, nitrogen, oxygen, and carbon in either tantalum (Ta) or an alloy containing Ta. Examples of the Ta compound include TaB, TaN, TaO, TaON, TaCON, TaBN, TaBO, TaBON, TaBCON, TaHf, TaHfO, TaHfN, TaHfON, TaHfCON, TaSi, TaSiO, TaSiN, TaSiON, TaSiCON, and the like. The film thickness of the back conductive film 5 is not particularly limited as long as a function for an electrostatic chuck is satisfied, but is usually 10 nm to 200 nm. The back conductive film 5 also adjusts stress on the second main surface side of the mask blank 100. That is, the back conductive film 5 is adjusted in such a manner as to obtain the flat reflective mask blank 100 in balance with stress from various films formed on the first main surface side.

Note that the substrate with a multilayer reflective film 90 does not necessarily include the back conductive film 5. For example, after the absorber film 4 described later is formed, the back conductive film 5 can be formed on the reflective mask blank 100.

<Reflective mask blank 100>

The reflective mask blank 100 of the present embodiment will be described. As illustrated in Fig. 2, the reflective mask blank 100 of the present embodiment includes the absorber film 4 on the protective film 3 of the above-described substrate with a multilayer reflective film 90.

<<Absorber film 4>>

The absorber film 4 of the reflective mask blank 100 of the present embodiment is formed on the protective film 3. A basic function of the absorber film 4 is to absorb EUV light. The absorber film 4 may be the absorber film 4 for the purpose of absorbing EUV light or may be the absorber film 4 having a phase shift function in consideration of a phase difference of EUV light. The absorber film 4 having a phase shift function absorbs EUV light and reflects a part of EUV light to shift a phase. That is, in the reflective mask 200 in which the absorber film 4 having a phase shift function is patterned, a portion where the absorber film 4 is formed reflects a part of light at a level that does not adversely affect pattern transfer while absorbing and attenuating EUV light. In addition, a region (field portion) where the absorber film 4 is not formed reflects EUV light by the multilayer reflective film 2 via the protective film 3. Therefore, there is a desired phase difference between the reflected light from the absorber film 4 having a phase shift function and the reflected light from the field portion. The absorber film 4 having a phase shift function is formed in such a manner that a phase difference between the reflected light from the absorber film 4 and the reflected light from the multilayer reflective film 2 is 170 degrees to 260 degrees. The light beams having an inverted phase difference interfere with each other at a pattern edge portion, and this improves an image contrast of a projection optical image. As the image contrast is improved, resolution is increased, and various tolerances regarding exposure, such as exposure tolerance and focus tolerance can be increased.

The absorber film 4 may be a single-layer film or a multilayer film including a plurality of films (for example, a lower absorber film and an upper absorber film). In a case of a single-layer film, there is a characteristic that the number of steps during manufacturing a mask blank can be reduced and that manufacturing efficiency is increased. In a case of a multilayer film, an optical constant and a film thickness of the multilayer film can be appropriately set such that an upper absorber film serves as an antireflection film during mask pattern defect inspection using light. This improves inspection sensitivity during mask pattern defect inspection using light. In addition, when a film to which oxygen (O), nitrogen (N), or the like that improves oxidation resistance is added is used as the upper absorber film, temporal stability is improved. In this manner, by forming the absorber film 4 into a multilayer film, various functions can be added. When the absorber film 4 is the absorber film 4 having a phase shift function, a range of adjustment in an optical surface can be increased by forming the absorber film 4 into a multilayer film, and therefore a desired reflectance is easily obtained.

A material of the absorber film 4 is not particularly limited as long as it has a function of absorbing EUV light, can be processed by etching or the like (preferably, can be etched by dry etching with a chlorine (Cl)-based gas and/or a fluorine (F)-based gas), and has a high etching selectivity ratio to the protective film 3 (third layer 38). As those having such a function, at least one metal or an alloy containing two or more metals selected from palladium (Pd), silver (Ag), platinum (Pt), gold (Au), iridium (Ir), tungsten (W), chromium (Cr), cobalt (Co), manganese (Mn), tin (Sn), tantalum (Ta), vanadium (V), nickel (Ni), hafnium (Hf), iron (Fe), copper (Cu), tellurium (Te), zinc (Zn), magnesium (Mg), germanium (Ge), aluminum (Al), rhodium (Rh), ruthenium (Ru), molybdenum (Mo), niobium (Nb), titanium (Ti), zirconium (Zr), yttrium (Y), and silicon (Si), or a compound thereof can be preferably used. The compound may contain oxygen (O), nitrogen (N), carbon (C), and/or boron (B) in addition to the metal or the alloy.

The absorber film 4 can be formed by a magnetron sputtering method such as a DC sputtering method or an RF sputtering method. For example, the absorber film 4 such as a tantalum compound can be deposited using a target containing tantalum and boron by a reactive sputtering method using an argon gas containing oxygen or nitrogen.

In addition, a crystalline state of the absorber film 4 is preferably an amorphous or microcrystalline structure from a viewpoint of smoothness and flatness. When a surface of the absorber film 4 is not smooth and flat, edge roughness of the absorber pattern 4a increases, and dimensional accuracy of the pattern may deteriorate. Surface roughness of the absorber film 4 is preferably 0.5 nm or less, more preferably 0.4 nm or less, and still more preferably 0.3 nm or less in terms of root mean square roughness (Rms).

In the present embodiment, it is possible to obtain the reflective mask blank 100 capable of suppressing a decrease in reflectance of the multilayer reflective film 2 with respect to EUV light even when the reflective mask blank 100 having a structure in which the protective film 3 made of a material containing metal is disposed on a high refractive index layer is subjected to heat treatment.

<<Etching mask film 6»

As illustrated in Fig. 3, the reflective mask blank 100 of the present embodiment can include the etching mask film 6 on the absorber film 4. As a material of the etching mask film 6, a material having a high etching selectivity ratio of the absorber film 4 to the etching mask film 6 (etching speed of the absorber film 4/etching speed of the etching mask film 6) is preferably used. The etching selectivity ratio of the absorber film 4 to the etching mask film 6 is preferably 1.5 or more, and more preferably 3 or more.

The reflective mask blank 100 of the present embodiment preferably includes the etching mask film 6 on the absorber film 4.

As a material of the etching mask film 6, chromium or a chromium compound is preferably used. Examples of the chromium compound include a material containing Cr and at least one element selected from N, O, C, and H. The etching mask film 6 more preferably contains CrN, CrO, CrC, CrON, CrOC, CrCN, or CrOCN, and is still more preferably a CrO-based film (CrO film, CrON film, CrOC film, or CrOCN film) containing chromium and oxygen.

As a material of the etching mask film 6, tantalum or a tantalum compound is preferably used. Examples of the tantalum compound include a material containing Ta and at least one element selected from N, O, B, and H. The etching mask film 6 more preferably contains TaN, TaO, TaON, TaBN, TaBO, or TaBON.

As a material of the etching mask film 6, silicon or a silicon compound is preferably used. Examples of the silicon compound include a material containing Si and at least one element selected from N, O, C, and H, metal silicon (metal silicide) containing metal in addition to silicon and a silicon compound, and a metal silicon compound (metal silicide compound). Examples of the metal silicon compound include a material containing metal, Si, and at least one element selected from N, O, C, and H.

The film thickness of the etching mask film 6 is preferably 3 nm or more in order to form a pattern on the absorber film 4 with high accuracy. In addition, the film thickness of the etching mask film 6 is preferably 15 nm or less in order to reduce the film thickness of the resist film 11.

<Reflective mask 200>

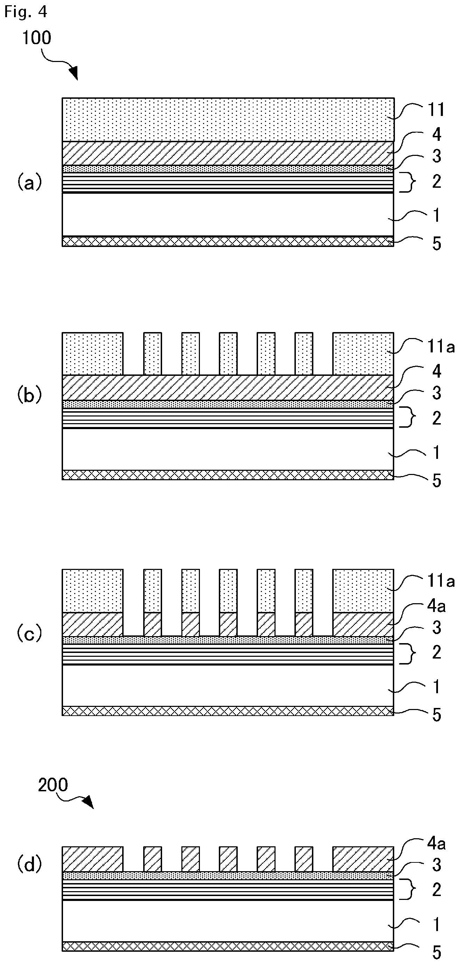

As illustrated in Fig. 4(d), the reflective mask 200 of the present embodiment includes the absorber pattern 4a obtained by patterning the absorber film 4 of the above-described reflective mask blank 100.

Figs. 4(a) to 4(d) are schematic views illustrating an example of a method for manufacturing the reflective mask 200. The reflective mask 200 of the present embodiment can be manufactured using the above-described reflective mask blank 100 of the present embodiment. Hereinafter, an example of a method for manufacturing the reflective mask 200 will be described.

First, the reflective mask blank 100 including the substrate 1, the multilayer reflective film 2 formed on the substrate 1, the protective film 3 formed on the multilayer reflective film 2, and the absorber film 4 formed on the protective film 3 is prepared. Next, the resist film 11 is formed on the absorber film 4 to obtain the reflective mask blank 100 with the resist film 11 (Fig. 4(a)). A pattern is drawn on the resist film 11 by an electron beam lithography apparatus, and the resulting product is further subjected to a development and rinsing step to form a resist pattern 11a (Fig. 4(b)).

The absorber film 4 is dry-etched using the resist pattern 11a as a mask. As a result, a portion of the absorber film 4 not covered with the resist pattern 11a is etched to form the absorber pattern 4a (Fig. 4(c)).

As an etching gas of the absorber film 4, for example, a fluorine-based gas and/or a chlorine-based gas can be used. As the fluorine-based gas, $CF_4$, $CHF_3$, $C_2F_6$, $C_3F_6$, $C_4F_6$, $C_4F_8$, $CH_2F_2$, $CH_3F$, $C_3F_8$, $SF_6$, $F_2$, and the like can be used. As the chlorine-based gas, $Cl_2$, $SiCl_4$, $CHCl_3$, $CCl_4$, $BCl_3$, and the like can be used. In addition, a mixed gas containing a fluorine-based gas and/or a chlorine-based gas and Oz at a predetermined ratio can be used. These etching gases can further contain an inert gas such as He and/or Ar as necessary.

After the absorber pattern 4a is formed, the resist pattern 11a is removed with a resist stripping solution. After the resist pattern 11a is removed, the resulting product is subjected to a wet cleaning step using an acidic or alkaline aqueous solution to obtain the reflective mask 200 of the present embodiment (Fig. 4(d)).

Note that, when the reflective mask blank 100 in which the etching mask film 6 is formed on the absorber film 4 is used, a step of forming a pattern (etching mask pattern) on the etching mask film 6 using the resist pattern 11a as a mask and then forming a pattern on the absorber film 4 using the etching mask pattern as a mask is added.

The reflective mask 200 thus obtained has a structure in which the multilayer reflective film 2, the protective film 3, and the absorber pattern 4a are laminated on the substrate 1.

A region (reflection region) where the multilayer reflective film 2 covered with the protective film 3 is exposed has a function of reflecting EUV light. A region where the multilayer reflective film 2 and the protective film 3 are covered with the absorber pattern 4a has a function of absorbing EUV light. The reflective mask 200 of the present embodiment can suppress a decrease in reflectance of the reflection region with respect to EUV light even when the reflective mask 200 is subjected to heat treatment. By using the reflective mask 200 of the present embodiment, a reflective region having a high reflectance with respect to EUV light can be obtained, and therefore a finer pattern can be transferred onto a transfer object in EUV lithography.

In the present embodiment, it is possible to obtain the reflective mask 200 capable of suppressing a decrease in reflectance of the multilayer reflective film 2 with respect to EUV light even when the reflective mask 200 having a structure in which the protective film 3 made of a material containing metal is disposed on a high refractive index layer is subjected to heat treatment.

<Method for manufacturing semiconductor device>

A method for manufacturing a semiconductor device of the present embodiment includes a step of performing a lithography process by an exposure apparatus using the above-described reflective mask 200 to form a transfer pattern on a transfer object.

By lithography using the reflective mask 200 of the present embodiment, a transfer pattern can be formed on a semiconductor substrate 60 (transfer object). This transfer pattern has a shape onto which the pattern of the reflective mask 200 is transferred. A semiconductor device can be manufactured by forming a transfer pattern on the semiconductor substrate 60 by the reflective mask 200.

According to the present embodiment, a semiconductor device can be manufactured using the reflective mask 200 obtained from the substrate with a multilayer reflective film 90 and the reflective mask blank 100 capable of suppressing a decrease in reflectance of the multilayer reflective film 2 with respect to EUV light even when the substrate with a multilayer reflective film 90 and the reflective mask blank 100 are subjected to heat treatment. Therefore, by using the reflective mask 200 of the present embodiment, it is possible to increase density and accuracy of the semiconductor device.

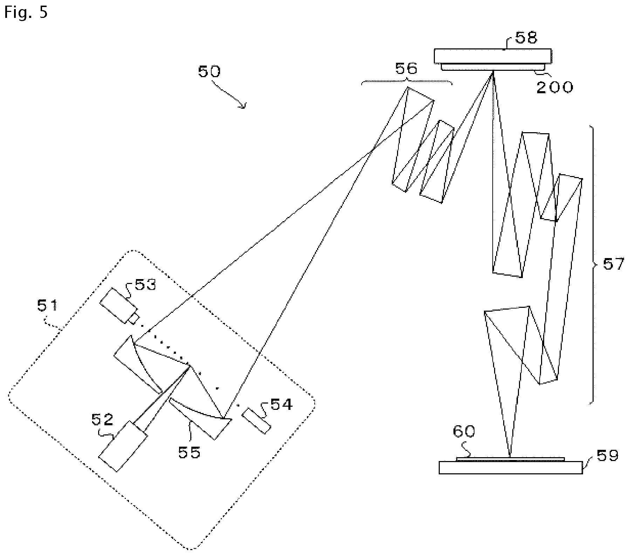

A method for transferring a pattern onto the semiconductor substrate 60 with resist by EUV light will be described with reference to Fig. 5.

Fig. 5 indicates a schematic configuration of an EUV exposure apparatus 50 that is an apparatus for transferring a transfer pattern onto a resist film formed on the semiconductor substrate 60. In the EUV exposure apparatus 50, an EUV light generating unit 51, an irradiation optical system 56, a reticle stage 58, a projection optical system 57, and a wafer stage 59 are precisely arranged along an optical path axis of EUV light. A container of the EUV exposure apparatus 50 is filled with a hydrogen gas.

The EUV light generating unit 51 includes a laser light source 52, a tin droplet generating unit 53, a capturing unit 54, and a collector 55. When a tin droplet emitted from the tin droplet generating unit 53 is irradiated with a high-power carbon dioxide gas laser from the laser light source 52, tin in a droplet state is turned into plasma, and EUV light is generated. The generated EUV light is collected by the collector 55, passes through the irradiation optical system 56, and enters the reflective mask 200 set on the reticle stage 58. The EUV light generating unit 51 generates, for example, EUV light having a wavelength of 13.53 nm.

The EUV light reflected by the reflective mask 200 is usually reduced to about 1/4 of pattern image light by the projection optical system 57 and projected onto the semiconductor substrate 60 (transfer substrate 1). As a result, a given circuit pattern is transferred onto the resist film on the semiconductor substrate 60. By developing the exposed resist film, a resist pattern can be formed on the semiconductor substrate 60. By etching the semiconductor substrate 60 using the resist pattern as a mask, an integrated circuit pattern can be formed on the semiconductor substrate 60. Through such steps and other necessary steps, a semiconductor device is manufactured.

Examples

Hereinafter, Examples will be described. These Examples do not limit the present invention.

(Examples 1 to 3)

As Examples 1 to 3, substrates with a multilayer reflective film 90 in each of which a multilayer reflective film 2 and a protective film 3 were formed on a first main surface of a substrate 1 were prepared. Table 1 presents the types of target materials and introduced gases for depositing a first layer 34, a second layer 36, and a third layers 38 of each of protective films 3 of Examples 1 to 3. The substrates with a multilayer reflective film 90 of Examples were prepared in a similar manner except that the types of target material at the time of depositing the protective films 3 were different from each other.

The substrates with a multilayer reflective film 90 of Examples were prepared as follows.

As the substrate 1, an $SiO_2$-$TiO_2$-based glass substrate that was a low thermal expansion glass substrate having a 6025 size (about 152 mm $\times$ 152 mm $\times$ 6.35 mm) with both surfaces of the first main surface and the second main surface polished was used. In order to obtain flat and smooth main surfaces, polishing including a rough polishing step, a precision polishing step, a local machining step, and a touch polishing step was performed.

Next, the multilayer reflective film 2 was formed on the first main surface of the substrate 1. The multilayer reflective film 2 was a periodic multilayer reflective film 2 made of Si and Mo in order to form the multilayer reflective film 2 suitable for EUV light having a wavelength of 13.5 nm. Specifically, a Si target and a Mo target were used as a target of a high refractive index material and a target of a low refractive index material, respectively. Krypton (Kr) ion particles were supplied from an ion source to these targets, and ion beam sputtering was performed to alternately laminate a Si layer and a Mo layer on the substrate 1.

Here, the sputtered particles of Si and Mo were incident at an angle of 30 degrees with respect to a normal line of the first main surface of the substrate 1. First, a Si layer was deposited in a thickness of 4.2 nm, and subsequently, a Mo layer was deposited in a thickness of 2.8 nm. This was defined as one period, and lamination was performed for 40 periods in a similar manner. Therefore, a material of the lowermost layer of the multilayer reflective film 2, that is, a material of the multilayer reflective film 2 closest to the substrate 1 is Si, and a material of an uppermost layer of the multilayer reflective film 2 is Mo.

Next, the protective film 3 including a silicon-containing layer 32, the first layer 34, the second layer 36, and the third layer 38 was formed on each of the multilayer reflective films 2 of Examples.

First, the silicon-containing layer 32 of the protective film 3 was formed on a surface of the multilayer reflective film 2. The silicon-containing layer 32 was formed under the same conditions as in the above-described method for forming the Si layer of the multilayer reflective film 2. At this time, the silicon-containing layer 32 was formed such that the film thickness of the silicon-containing layer 32 was 4.0 nm from a relationship between a deposition speed and a deposition time of the Si layer under predetermined conditions. Note that, as described later, after the first layer 34, the second layer 36, and the third layer 38 were formed, the film thickness of the silicon-containing layer 32 was measured and found to be 1.4 nm. It is considered that since a part of Si in the silicon-containing layer 32 was diffused into the first layer 34 and the like, the thickness was thinner than a film thickness calculated from the relationship between the deposition speed and the deposition time.

Next, the first layer 34, the second layer 36, and the third layer 38 presented in Table 1 were formed on a surface of the silicon-containing layer 32. The first layer 34, the second layer 36, and the third layer 38 were continuously formed by a DC magnetron sputtering method (reactive sputtering method) in a nitrogen ($N_2$) gas atmosphere using a sintered target of a material presented in Table 1.

A composition profile of a protective film 3 in a depth direction manufactured under similar conditions to those of the protective films 3 of Examples was measured by an XPS method. As a result, it was confirmed that the first layer 34, the second layer 36, and the third layer 38 could be formed such that the three layers each had a predetermined composition without changing the deposition conditions in the middle.

The film thicknesses of the silicon-containing layer 32, the first layer 34, the second layer 36, and the third layer 38 obtained from the composition profile in the depth direction measured by the XPS method were 1.4 nm, 0.9 nm, 1.1 nm, and 3.8 nm, respectively.

Table 1 presents a measurement depth d1 (nm) of the first layer 34, a measurement depth d2 (nm) of the second layer 36, and a measurement depth d3 (nm) of the third layer 38. The measurement depths d1 to d3 are each a distance in the depth direction of the protective film 3 from a surface of the protective film 3. The composition of the protective film 3 was measured in the depth direction from the surface by the XPS method. Note that, in a range of the first layer 34, a depth at which a local maximum value of the content of a predetermined metal occurred was defined as the measurement depth d1 of the first layer 34. In addition, in a range of the second layer 36, a depth at which a local maximum value of the content of nitrogen occurred was defined as the measurement depth d2 of the second layer 36. In addition, in a range of the third layer 38, a depth at which a local maximum value of the content of a predetermined metal occurred was defined as the measurement depth d3 of the third layer 38. The predetermined metal is Ru, Rh, or RuRh. From the compositions at the measurement depths d1 to d3, the nitrogen contents (N1, N2, and N3) of the first layer 34, the second layer 36, and the third layer 38, the metal contents (M1, M2 and M3) of the first layer 34, the second layer 36 and the third layer 38, and the silicon contents (Si1, Si2, and Si3) of the first layer 34, the second layer 36 and the third layer 38 were determined. The "metal content" is the total content of Ru and Rh, and is the Ru content in Example 1, the Rh content in Example 2, and the total content of Ru and Rh in Example 3.

Table 1 presents the nitrogen contents (N1, N2, and N3) of the first layer 34, the second layer 36, and the third layer 38. In addition, Table 1 presents values of a content ratio of nitrogen and a content ratio of metal calculated based on the nitrogen content, the metal content, and the silicon content of each layer. It can be understood from Table 1 that Examples 1 to 3 satisfy all of the following relationships.

Relationship between nitrogen contents: $N2 > N1 \geq N3$ and $N2 > N1 > N3$

Relationship between nitrogen content ratios:

$$N2/(N2+Si2+M2)>N1/(N1+Si1+M1)>N3/(N3+Si3+M3)$$

Relationship between metal content ratios:

$$M3/(N3+Si3+M3)>M1/(N1+Si1+M1)>M2/(N2+Si2+M2)$$

The substrates with a multilayer reflective film 90 of Examples were manufactured as described above.

(Comparative examples 1 to 3)

Substrates with a multilayer reflective film 90 of Comparative Examples 1 to 3 were manufactured in a similar manner to Example 1 except that a protective film 3 included two layers of a silicon-containing layer 32 and a third layer 38. Table 2 presents target materials and introduced gases at the time of depositing the third layers 38 of Comparative Examples 1 to 3. Note that each of the third layers 38 of Comparative Examples 1 to 3 was deposited in a thickness of 3.5 nm by a DC magnetron sputtering method using a target of a material presented in Table 1 in a Kr gas atmosphere. That is, a $N_2$ gas was not used at the time of depositing the third layers 38 of Comparative Examples 1 to 3. It was confirmed that the third layer 38 in which the metal presented in Table 2 had a substantially uniform composition in the depth direction could be formed under the deposition conditions. Note that, since a $N_2$ gas was not used at the time of depositing the third layers 38 of Comparative Examples, it was confirmed that the third layers 38 of Comparative Examples 1 to 3 contained substantially no nitrogen (N). In addition, in each of the protective films 3 of Comparative Examples 1 to 3, there were no layers corresponding to the first layer 34 and the second layer 36. The substrates with a multilayer reflective film 90 of Comparative Examples 1 to 3 were manufactured as described above.

(Evaluation of substrate with a multilayer reflective film 90)

Using the substrates with a multilayer reflective film 90 of Examples and Comparative Examples prepared as described above, a change in reflectance due to heat treatment to the substrates with a multilayer reflective film 90 was measured.

Specifically, first, a reflectance (R1, unit: %) of each of the substrates with a multilayer reflective film 90 of Examples and Comparative Examples with respect to EUV light (wavelength 13.5 nm) was measured. Next, the substrates with a multilayer reflective film 90 were subjected to heat treatment by being heated at 200°C for 10 minutes in the air atmosphere. After the substrates with a multilayer reflective film 90 were subjected to heat treatment, a reflectance (R2, unit: %) of each of the substrates with a multilayer reflective film 90 with respect to EUV light was measured. By subtracting the value of the reflectance (R2) of the substrate with a multilayer reflective film 90 after the heat treatment from the value of the reflectance (R1) of the substrate with a multilayer reflective film 90 before the heat treatment, a change in the EUV reflectance of the substrate with a multilayer reflective film 90 due to the heat treatment was obtained. The change in EUV reflectance due to the heat treatment is presented in "reflectance change (%)" column of Tables 1 and 2. As can be understood from the fact that all the changes in the EUV reflectance presented in Tables 1 and 2 are negative values, the EUV reflectance was reduced by the heat treatment in all the cases of Examples and Comparative Examples.

Table 3 presents a ratio of the reflectance change (%) between Example and Comparative Example in a case of the protective film 3 made of the same metal. For example, the metals of Example 1 and Comparative Example 1 are both Ru and the same metal. The "reflectance change ratio" column of "Example 1/Comparative Example 1" in Table 3 presents a ratio obtained by dividing the reflectance change (%) of Example 1 by the reflectance change (%) of Comparative Example 1. This ratio is the reflectance change ratio when the metal is Rh. Similarly, "Example 2/Comparative Example 2" in Table 3 is a reflectance change ratio when the metal is Rh, and "Example 3/Comparative Example 3" is a reflectance change ratio when the metal is RuRh.

As presented in Table 3, in the substrates with a multilayer reflective film 90 of Examples 1 to 3, a ratio of the change in reflectance to EUV light was 0.75 (comparison between Example 3 and Comparative Example 3, case of RuRh) or less when the same metal was used as the protective films 3 before and after the heat treatment at 200°C for 10 minutes. In each of the protective films 3 of Examples 1 to 3, since the predetermined first layer 34, second layer 36, and third layer 38 containing nitrogen were disposed, it is considered that diffusion of silicon from the silicon-containing layer 32 to the third layer 38 was suppressed. Therefore, it is presumed that the change in reflectance was small before and after the heat treatment.

(Reflective mask blank 100)

Next, reflective mask blanks 100 of Examples will be described.

A back conductive film 5 was formed on a back surface of each of the substrates 1 of the substrates with a multilayer reflective film 90 manufactured as described above, and an absorber film 4 was formed on the protective film 3, thereby manufacturing the reflective mask blanks 100 of Examples 1 to 3.

First, the back conductive film 5 made of a CrN film was formed on a second main surface (back surface) of the substrate 1 of the substrate with a multilayer reflective film 90 by a magnetron sputtering (reactive sputtering) method under the following conditions.

Conditions for forming back conductive film 5: a Cr target, a mixed gas atmosphere of Ar and $N_2$ (Ar: 90%, N: 10%), and a film thickness of 20 nm.

Next, a TaBN film having a film thickness of 55 nm was formed as the absorber film 4 on the protective film 3 of the substrate with a multilayer reflective film 90. The absorber film 4 had a composition of Ta : B : N = 75 : 12 : 13 (atomic ratio), and a film thickness of 55 nm.

In this manner, the reflective mask blanks 100 of Examples were manufactured.

(Reflective mask 200)

Next, a reflective mask 200 was manufactured using each of the reflective mask blanks 100 of Examples 1 to 3. The manufacture of the reflective mask 200 will be described with reference to Fig. 4.

First, as illustrated in Fig. 4(a), on the absorber film 4 of the reflective mask blank 100, a resist film 11 was formed. Then, a desired pattern such as a circuit pattern was drawn (exposed) on the resist film 11, and further developed and rinsed to form a predetermined resist pattern 11a (Fig. 4(b)). Next, using the resist pattern 11a as a mask, the absorber film 4 (TaBN film) was dry-etched using a $Cl_2$ gas to form an absorber pattern 4a (Fig. 4(c)). Thereafter, the resist pattern 11a was removed (Fig. 4(d)).

Finally, wet cleaning using pure water (DIW) was performed to manufacture reflective masks 200 of Examples 1 to 3.

(Manufacture of semiconductor device)

Each of the reflective masks 200 of Examples 1 to 3 was set in an EUV scanner, and EUV exposure was performed on a wafer in which a film to be processed and a resist film were formed on a semiconductor substrate 60 as a transfer object. Then, the exposed resist film was developed to form a resist pattern on the semiconductor substrate 60 on which the film to be processed was formed.

In each of the reflective masks 200 of Examples 1 to 3, since the protective film 3 includes the predetermined first layer, second layer, and third layer, it is considered that diffusion of Si from the silicon-containing layer to the third layer was suppressed as compared with a case of using the same metal as the protective film. Therefore, by using the reflective masks 200 of Examples 1 to 3, a fine and highly accurate transfer pattern (resist pattern) could be formed on the semiconductor substrate 60 (transfer substrate).

This resist pattern was transferred onto the film to be processed by etching, and the resulting product was subjected to various steps such as forming an insulating film and a conductive film, introducing a dopant, and annealing, whereby a semiconductor device having desired characteristics could be manufactured at a high yield.

(Examples 4 and 5)

As each of Examples 4 and 5, the first layer 34, the second layer 36, and the third layer 38 were formed on the multilayer reflective film 2 and the silicon-containing layer 32 deposited on the first main surface of the substrate, which were prepared in a similar manner to Example 1. Table 4 presents the types of target materials and introduced gases for depositing the first layer, the second layer, and the third layers of each of the protective films 3 of Examples 4 and 5. A target composition ratio of Examples 4 and 5 is Ru : Rh : Cr = 60 : 30 : 10. The first layer 34, the second layer 36, and the third layer 38 were continuously formed by a DC magnetron sputtering method (reactive sputtering method) in a $N_2$ gas and an Ar gas or a $N_2$ gas atmosphere using a sintered target of a material presented in Table 4.

The substrates with a multilayer reflective film 90 of Examples 4 and 5 were manufactured as described above. A buffer layer made of a TaBO film was formed on the protective film 3 of the substrate with a multilayer reflective film 90 manufactured as described above by a magnetron sputtering method (reactive sputtering method). The buffer layer was deposited so as to have a film thickness of 3 nm in a mixed gas atmosphere of an Ar gas and an Oz gas using a TaB target. Next, an absorption layer made of a RuCrN film was formed on the buffer layer by a magnetron sputtering method (reactive sputtering method). The absorption layer was deposited so as to have a film thickness of 45 nm in a mixed gas atmosphere of a Kr gas and a $N_2$ gas using a Ru target and a Cr target.

Next, a back conductive film 5 made of a CrN film was formed on the second main surface (back surface) of the substrate in the substrate with a multilayer reflective film 90 by a magnetron sputtering method (reactive sputtering method). The back conductive film 5 was deposited so as to have a film thickness of 20 nm in a mixed gas atmosphere of an Ar gas and a $N_2$ gas using a Cr target.

In this manner, the reflective mask blanks of Examples 4 and 5 were manufactured. Then, the reflective mask blanks were measured by an EDX method.

For the measurement, an analyzer in which an EDX apparatus (JED-2300T manufactured by JEOL) was connected to a scanning transmission electron microscope (JEM-ARM200F manufactured by JEOL) was used. Measurement conditions were as follows.

Acceleration voltage of electron beam: 200 kV
Camera length: 80 cm
EDX mapping resolution: 256 × 256 pixels
Field of view of EDX mapping: 20 nm × 20 nm

As a result, it was confirmed that the first layer 34, the second layer 36, and the third layer 38 in each of Examples 4 and 5 could be formed such that the three layers each had a predetermined composition without changing the deposition conditions in the middle.

Table 4 presents results of measuring a composition profile of the protective film 3 in a depth direction. Table 4 presents a measurement depth d1 (nm) of the first layer 34, a measurement depth d2 (nm) of the second layer 36, and a measurement depth d3 (nm) of the third layer 38. The measurement depths d1 to d3 are each a distance in the depth direction of the protective film 3 from a surface of the protective film 3. Note that, in a range of the first layer 34, a depth at which a local maximum value of M/(N + M), which is a ratio of a predetermined metal content M and a nitrogen content N, occurred was defined as the measurement depth d1 of the first layer 34. In addition, in a range of the second layer 36, a depth at which a local minimum value of M/(N + M) occurred was defined as the measurement depth d2 of the second layer 36. In addition, in a range of the third layer 38, a depth at which a local maximum value of M/(N + M) occurred was defined as the measurement depth d3 of the third layer 38. The predetermined metal is RuRh excluding an additive element. From the compositions at the measurement depths d1 to d3, the nitrogen contents (N1, N2, and N3) of the first layer 34, the second layer 36, and the third layer 38, and the metal contents (M1, M2 and M3) of the first layer 34, the second layer 36 and the third layer 38 were determined. Here, the "metal content" is the total content of Ru and Rh.

Table 4 presents the nitrogen contents (N1, N2, and N3) of the first layer 34, the second layer 36, and the third layer 38. In addition, Table 4 presents a value of a metal content ratio calculated based on a nitrogen content and a metal content in each layer. It can be understood from Table 4 that Examples 4 and 5 satisfy all of the following relationships.

Relationship between nitrogen contents: N2>N3>N1

Relationship between metal content ratios:

$$M3/(N3+M3)>M1/(N1+M1)>M2/(N2+M2)$$

(Comparative Example 4)

A substrate with a multilayer reflective film 90 of Comparative Example 4 was manufactured in a similar manner to Example 4 except that a protective film 3 included two layers of a silicon-containing layer 32 and a third layer 38. The third layer 38 of Comparative Example 4 was deposited in a thickness of 3.5 nm by a DC magnetron sputtering method using the same RuRhCr target as in Example 4 in an Ar gas atmosphere. Note that, since a $N_2$ gas was not used at the time of depositing the third layers 38 of Comparative Example 4, it was confirmed that the third layer 38 of Comparative Example 4 contained substantially no nitrogen (N). In addition, in the protective film 3 of Comparative Example 4, there were no layers corresponding to the first layer 34 and the second layer 36. The substrate with a multilayer reflective film 90 of Comparative Example 4 was manufactured as described above.

The substrate with a multilayer reflective film 90 was evaluated. Using substrates with a multilayer reflective film 90 prepared in a similar manner to Comparative Example 4 and Examples 4 and 5, a change in reflectance due to heat treatment to the substrates with a multilayer reflective film 90 was measured in a similar manner to Example 1. Table 4 presents a ratio obtained by dividing each of the reflectance changes (%) of Examples 4 and 5 by the reflectance change (%) of Comparative Example 4.

As presented in Table 4, in the substrates with a multilayer reflective film 90 of Examples 4 and 5, a ratio of the change in reflectance to EUV light was 0.80 or less when RuRhCr was used as the protective films 3 before and after the heat treatment at 200°C for 10 minutes. In each of the protective films 3 of Examples 4 and 5, since the predetermined first layer 34, second layer 36, and third layer 38 containing nitrogen were disposed, it is considered that diffusion of silicon from the silicon-containing layer 32 to the third layer 38 was suppressed. Therefore, it is presumed that the change in reflectance was small before and after the heat treatment.

[Table 1]

|  | Example 1 | Example 2 | Example 3 |
|---|---|---|---|
| Target material for depositing first to third layers | Ru | Rh | RuRh |
| Introduced gas for depositing first to third layers | $N_2$ gas | $N_2$ gas | $N_2$ gas |
| Measurement depth d3 of third layer (nm) | 1 | 0.5 | 0.5 |
| Measurement depth d2 of second layer (nm) | 4 | 4 | 4 |
| Measurement depth d1 of first layer (nm) | 5.5 | 5 | 4.75 |
| N1 (atom%) | 4.8 | 8.1 | 4 |
| N2 (atom%) | 18 | 14.9 | 11.3 |
| N3 (atom%) | 3.1 | 3 | 3.1 |
| N1/(N1 + Si1 + M1) | 0.09 | 0.12 | 0.05 |
| N2/(N2 + Si2 + M2) | 0.21 | 0.17 | 0.13 |
| N3/(N3 + Si3 + M3) | 0.03 | 0.03 | 0.03 |
| M1/(N1 + Si1 + M1) | 0.35 | 0.35 | 0.45 |
| M2/(N2 + Si2 + M2) | 0.25 | 0.29 | 0.36 |
| M3/(N3 + Si3 + M3) | 0.86 | 0.89 | 0.88 |
| Reflectance change (%) | -1.1 | -4.8 | -3.6 |

[Table 2]

|  | Comparative Example 1 | Comparative Example 2 | Comparative Example 3 |
|---|---|---|---|
| Target material for depositing protective film (third layer) | Ru | Rh | RuRh |
| Introduced gas for depositing protective film (third layer) | Kr gas | Kr gas | Kr gas |
| Reflectance change (%) | -2.3 | -9.8 | -4.8 |

[Table 3]

|  | Example 1/Comparative Example 1 | Example 1/Comparative Example 2 | Example 1/Comparative Example 3 |
|---|---|---|---|
| Metal of protective film | Ru | Rh | RuRh |
| Reflectance change ratio (Example/Comparative Example) | 0.48 | 0.49 | 0.75 |

[Table 4]

|  | Example 4 | Example 5 |
|---|---|---|
| Target composition ratio for depositing first to third layers | Ru:Rh:Cr=60:30:10 | Ru:Rh:Cr=60:30:10 |
| Introduced gas for depositing first to third layers | $N_2$ (10sccm), Ar (20sccm) | $N_2$ (30sccm) |
| Measurement depth d3 of third layer (nm) | 1.5 | 1.5 |
| Measurement depth d2 of second layer (nm) | 3.2 | 4.5 |
| Measurement depth d1 of first layer (nm) | 6.1 | 7.2 |
| N1 (atom%) | 2.0 | 1.7 |
| N2 (atom%) | 11.5 | 29.0 |
| N3 (atom%) | 3.8 | 5.6 |
| M1/(N1 + M1) | 0.920 | 0.744 |
| M2/(N2 + M2) | 0.810 | 0.276 |
| M3/(N3 + M3) | 0.942 | 0.931 |
| Reflectance change ratio (Example/Comparative Example) | 0.80 | 0.47 |

Reference Signs List

1       substrate
2       multilayer reflective film
3       protective film
4       absorber film
4a      absorber pattern
5       back conductive film
6       etching mask film
11      resist film

11a    resist pattern
32    silicon-containing layer
34    first layer
36    second layer
38    third layer
50    EUV exposure apparatus
51    EUV light generating unit
52    laser light source
53    tin droplet generating unit
54    capturing unit
55    collector
56    irradiation optical system
57    projection optical system
58    reticle stage
59    wafer stage
60    semiconductor substrate
90    substrate with a multilayer reflective film
100    reflective mask blank
200    reflective mask

**Claims**

1. A substrate with a multilayer reflective film (90) comprising a substrate (1), a multilayer reflective film (2) on the substrate (1), and a protective film (3) on the multilayer reflective film (2), wherein

   the protective film (3) includes a silicon-containing layer (32), a first layer (34), a second layer (36), and a third layer (38) in this order on the multilayer reflective film (2),
   the protective film (3) contains metal and nitrogen, and
   when a nitrogen content of the first layer (34) is represented by N1, a nitrogen content of the second layer (36) is represented by N2, and a nitrogen content of the third layer (38) is represented by N3, N2 is larger than N1 and N3.

2. The substrate with a multilayer reflective film (90) according to claim 1, wherein

   when a metal content of the first layer (34) is represented by M1, a metal content of the second layer (36) is represented by M2, and a metal content of the third layer (38) is represented by M3,
   a relationship of $(M3/(N3 + M3) > M1/(N1 + M1) > M2/(N2 + M2))$ is satisfied.

3. The substrate with a multilayer reflective film (90) according to claim 1 or 2, wherein the first layer (34), the second layer (36), and the third layer (38) satisfy a relationship of $N2 > N1 \geq N3$.

4. The substrate with a multilayer reflective film (90) according to claim 1 or 2, wherein the first layer (34), the second layer (36), and the third layer (38) satisfy a relationship of $N2 > N3 > N1$.

5. The substrate with a multilayer reflective film (90) according to claim 1 or 2, wherein the metal is at least one selected from ruthenium (Ru), rhodium (Rh), and iridium (Ir) .

6. The substrate with a multilayer reflective film (90) according to claim 1 or 2, wherein the protective film (3) further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu).

7. A reflective mask blank (100) comprising a substrate (1), a multilayer reflective film (2) on the substrate (1), a protective film (3) on the multilayer reflective film (2), and an absorber film (4) on the protective film (3), wherein

   the protective film (3) includes a silicon-containing layer (32), a first layer (34), a second layer (36), and a third layer (38) in this order on the multilayer reflective film (2),
the protective film (3) contains metal and nitrogen, and
when a nitrogen content of the first layer (34) is represented by N1, a nitrogen content of the second layer (36) is represented by N2, and a nitrogen content of the third layer (38) is represented by N3, N2 is larger than N1 and N3.

8. The reflective mask blank (100) according to claim 7, wherein

when a metal content of the first layer (34) is represented by M1, a metal content of the second layer (36) is represented by M2, and a metal content of the third layer (38) is represented by M3, a relationship of (M3/(N3 + M3) > M1/(N1 + M1) > M2/(N2 + M2)) is satisfied.

9. The reflective mask blank (100) according to claim 7 or 8, wherein the first layer (34), the second layer (36), and the third layer (38) satisfy a relationship of N2 > N1 ≥ N3.

10. The reflective mask blank (100) according to claim 7 or 8, wherein the first layer (34), the second layer (36), and the third layer (38) satisfy a relationship of N2 > N3 > N1.

11. The reflective mask blank (100) according to claim 7 or 8, wherein the metal is at least one selected from ruthenium (Ru), rhodium (Rh), and iridium (Ir).

12. The reflective mask blank (100) according to claim 7 or 8, wherein the protective film (3) further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu).

13. A reflective mask (200) comprising a substrate (1), a multilayer reflective film (2) on the substrate (1), a protective film (3) on the multilayer reflective film (2), and an absorber pattern (4a) on the protective film (3), wherein

the protective film (3) includes a silicon-containing layer (32), a first layer (34), a second layer (36), and a third layer (38) in this order on the multilayer reflective film (2),
the protective film (3) contains metal and nitrogen, and
when a nitrogen content of the first layer (34) is represented by N1, a nitrogen content of the second layer (36) is represented by N2, and a nitrogen content of the third layer (38) is represented by N3, N2 is larger than N1 and N3.

14. The reflective mask (200) according to claim 13, wherein

when a metal content of the first layer (34) is represented by M1, a metal content of the second layer (36) is represented by M2, and a metal content of the third layer (38) is represented by M3, a relationship of (M3/(N3 + M3) > M1/(N1 + M1) > M2/(N2 + M2)) is satisfied.

15. The reflective mask (200) according to claim 13 or 14, wherein the first layer (34), the second layer (36), and the third layer (38) satisfy a relationship of N2 > N1 ≥ N3.

16. The reflective mask (200) according to claim 13 or 14, wherein the first layer (34), the second layer (36), and the third layer (38) satisfy a relationship of N2 > N3 > N1.

17. The reflective mask (200) according to claim 13 or 14, wherein the metal is at least one selected from ruthenium (Ru), rhodium (Rh), and iridium (Ir).

18. The reflective mask (200) according to claim 13 or 14, wherein the protective film (3) further contains at least one additive element selected from thallium (Tl), hafnium (Hf), titanium (Ti), zirconium (Zr), manganese (Mn), indium (In), gallium (Ga), bismuth (Bi), tantalum (Ta), lead (Pb), silver (Ag), aluminum (Al), vanadium (V), niobium (Nb), tin (Sn), zinc (Zn), chromium (Cr), iron (Fe), antimony (Sb), tungsten (W), molybdenum (Mo), and copper (Cu).

19. A method for manufacturing a semiconductor device, the method comprising performing a lithography process by an exposure apparatus using the reflective mask (200) according to claim 13 or 14 to form a transfer pattern on a

transfer object.

Fig. 1

Fig. 2

Fig. 3

Fig. 4

100

(a)

11
4
3
2
1
5

(b)

11a
4
3
2
1
5

(c)

11a
4a
3
2
1
5

200

(d)

4a
3
2
1
5

Fig. 5

## INTERNATIONAL SEARCH REPORT

| International application No. |
|---|
| **PCT/JP2022/040039** |

### A.    CLASSIFICATION OF SUBJECT MATTER

*G03F 1/24*(2012.01)i; *G03F 7/20*(2006.01)i
FI:    G03F1/24; G03F7/20 503; G03F7/20 521

According to International Patent Classification (IPC) or to both national classification and IPC

### B.    FIELDS SEARCHED

Minimum documentation searched (classification system followed by classification symbols)

G03F1/24; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| A | WO 2020/256064 A1 (HOYA CORPORATION) 24 December 2020 (2020-12-24)<br>paragraphs [0040]-[0049] | 1-19 |
| A | JP 2014-127630 A (ASAHI GLASS CO LTD) 07 July 2014 (2014-07-07)<br>paragraphs [0059]-[0076], fig. 3 | 1-19 |
| A | WO 2012/014904 A1 (ASAHI GLASS CO LTD) 02 February 2012 (2012-02-02)<br>paragraphs [0029]-[0046], fig. 1 | 1-19 |

☐ Further documents are listed in the continuation of Box C.          ☑ See patent family annex.

| | |
|---|---|
| *        Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **22 December 2022** | **10 January 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

| International application No. |
| --- |
| **PCT/JP2022/040039** |

| Patent document cited in search report | | | Publication date (day/month/year) | Patent family member(s) | Publication date (day/month/year) |
| --- | --- | --- | --- | --- | --- |
| WO | 2020/256064 | A1 | 24 December 2020 | US 2022/0229357 A1 paragraphs [0061]-[0070] KR 10-2022-0022474 A | |
| JP | 2014-127630 | A | 07 July 2014 | US 2014/0186752 A1 paragraphs [0116]-[0175], fig. 3 KR 10-2014-0085350 A | |
| WO | 2012/014904 | A1 | 02 February 2012 | US 2013/0115547 A1 paragraphs [0049]-[0090], fig. 1 EP 2600388 A1 CN 103026296 A KR 10-2013-0111524 A | |

Form PCT/ISA/210 (patent family annex) (January 2015)

**REFERENCES CITED IN THE DESCRIPTION**

**Patent documents cited in the description**

- WO 2012014904 A
- WO 2011071123 A